(19) Europäisches Patentamt
European Patent Office
Office européen des brevets

(11) Publication number: 0 355 851 A2

(12) EUROPEAN PATENT APPLICATION

(21) Application number: 89115741.4

(22) Date of filing: 25.08.89

(51) Int. Cl.⁴: G11C 7/00 , G11C 8/00 , H04N 5/14

(30) Priority: 25.08.88 JP 211418/88

(43) Date of publication of application:
28.02.90 Bulletin 90/09

(84) Designated Contracting States:
DE FR GB

(71) Applicant: KABUSHIKI KAISHA TOSHIBA
72, Horikawa-cho Saiwai-ku
Kawasaki-shi Kanagawa-ken 210(JP)

(72) Inventor: Kobayashi, Makiji
1-1-806, Yokodai 1-chome Isogo-ku
Yokoyama-shi Kanagawa-Ken(JP)
Inventor: Higuchi, Akira 104, Maison
Kawahara
3-3-20, Nakahara Isogo-Ku
Yokohama-Shi Kanagawa-Ken(JP)

(74) Representative: Lehn, Werner, Dipl.-Ing. et al
Hoffmann, Eitle & Partner Patentanwälte
Arabellastrasse 4
D-8000 München 81(DE)

(54) Dynamic RAM for storing video frame.

(57) A dynamic RAM for storing video frame comprises a first memory cell array ($20_1$) for storing an odd field of the video frame, a second memory cell array ($20_2$) for storing an even field of the video frame, a circuit (2, 4, 5, 22, 24 and 25) for receiving address signals and accessing a memory cell specified by the address signals in one of the first and second memory cell arrays, and a circuit (25, $23_1$ and $23_2$) for executing precharge of the other one of the first and second memory cell arrays which does not contain the memory cell specified by the adress signals. When a memory cell in one of the first and second memory cell arrays is being accessed, precharge is executed in the other array. Then when a subsequent memory cell is accessed, the access can be immediately executed because the precharge of the cell has already been finished.

FIG. 5

## DYNAMIC RAM FOR STORING VIDEO FRAME

### BACKGROUND OF THE INVENTION

This invention relates to a dynamic RAM (Random Access Memory) for storing video frame.

The dynamic memory cell needs precharging before access. As the precharge is preparation for maintaining stable operation of the internal circuits in a memory device, the device cannot be stably operated without full precharge.

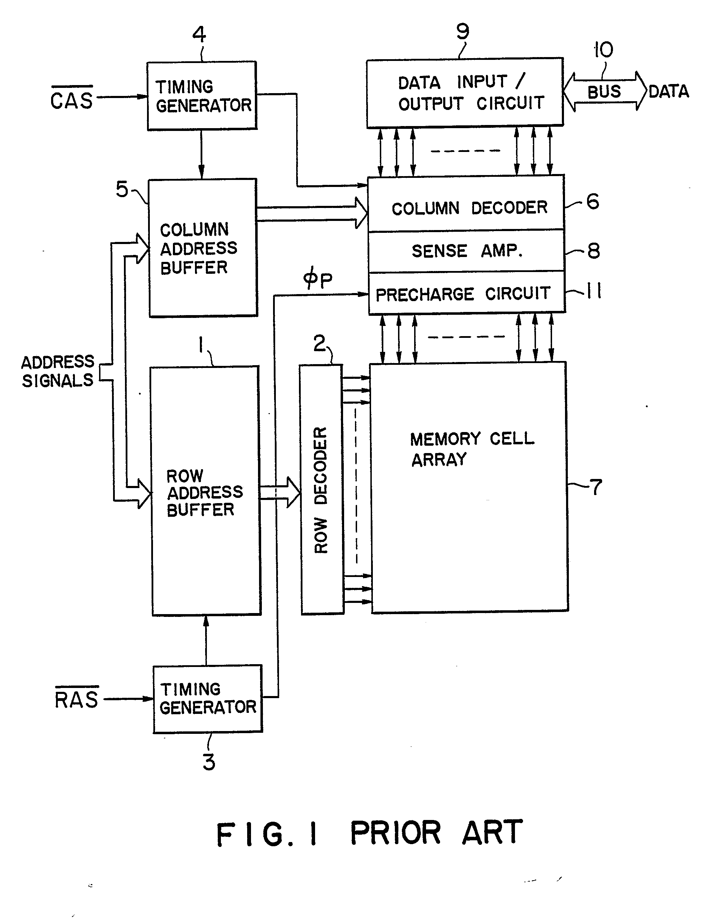

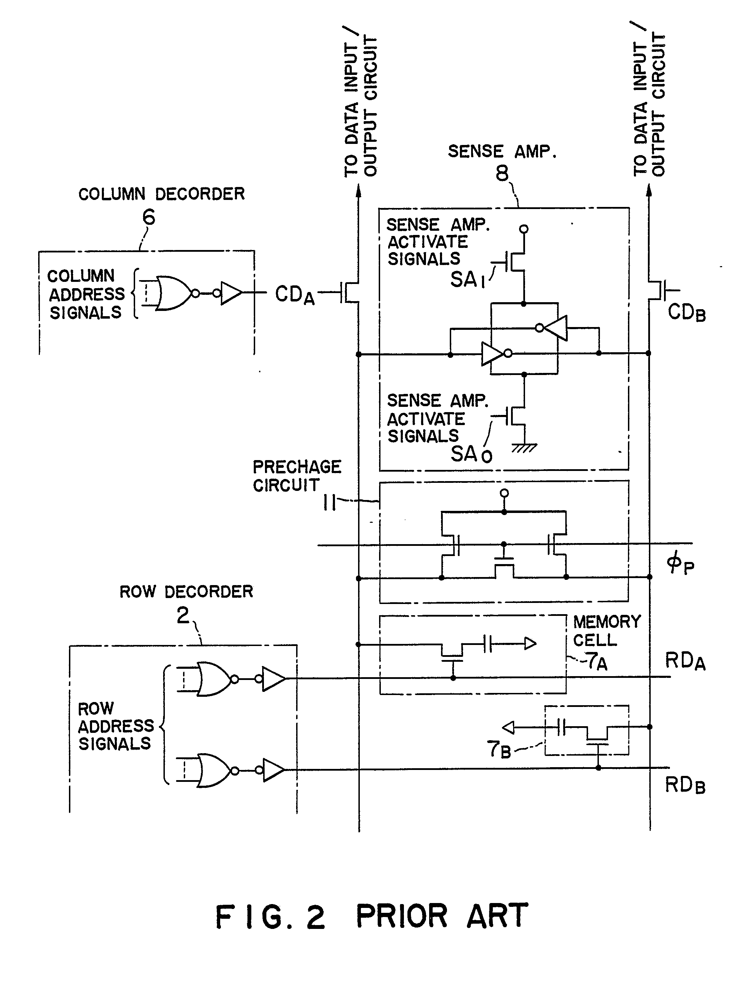

Here, by referring to FIGS. 1 and 2, a general circuit configuration and access and precharge operations of a dynamic memory are briefly described. As in FIG. 1, a row address signals are first added to the row decoder 2 through a row address buffer 1. This operation is made by synchronization with a down edge of row address strobe ( $\overline{RAS}$ ) signal provided to the timing generator 3. In the next place a column address signals are added to the column decoder 6 through the column address buffer 5 in synchronization with a down edge of column address strobe ( $\overline{CAS}$ ) signal provided to the timing generator 4. Further, referring to FIG. 2, if a row address signals are added to the row decoder 2, the corresponding row address decode signal such as $RD_A$ is provided to the memory cell array 7. This operation selects a row in the memory cell array 7 and, in the case of read-out, the signals of the memory cells $7_A$ in all columns belonging to the same row is read out and each signal is converted into a logic signal of a predetermined level with the sense amplifier 8. Then, if a column address signals are added to a column decoder 6, a corresponding column address decode signal, for example $CD_A$, is output and only a logical signal from one column is transferred to the data input/output circuit 9 and read out to a data bus 10. As illustrated in FIG. 1 and FIG. 2 the precharge circuit 11 is separately installed in each of columns. The precharge signal is simultaneously supplied to the precharge circuits 11 of all columns, and cells, $7_A$ and $7_B$, of all columns are simultaneously precharged. The precharge signal $\Phi_P$ is, as illustrated in FIG. 1, generated in the timing generator 3 depending on the $\overline{RAS}$ signal, and added to the precharge circuit 11.

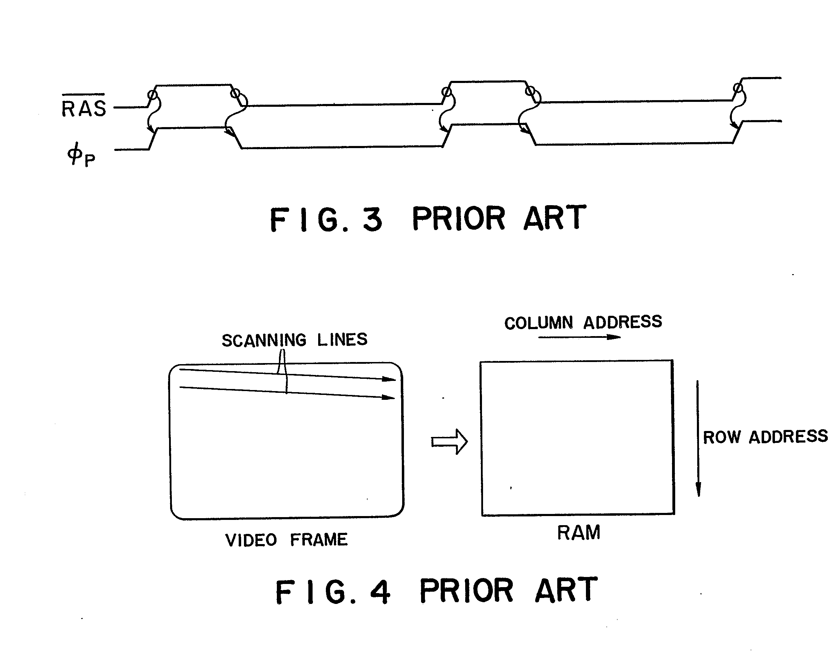

FIG. 3 illustrates a timing when the precharge signal $\Phi_P$ is generated in a dynamic memory. As illustrated in this figure the precharge signal $\Phi_P$ is generated at the same timing as the $\overline{RAS}$ signal. Therefore, every time the $\overline{RAS}$ signal reaches a high level in advance of reading row address signals, the precharge of all columns is carried out. Executing the precharge in every access becomes an obstacle to the fast access. In order to minimize the frequency of the precharge, an operation called a page mode is adopted. This operation specifies a row address synchronizing with $\overline{RAS}$ signal and then column addresses belonging to the same row one by one synchronizing with $\overline{CAS}$ signals. This method can change column addresses at a high speed because the precharge is not performed during the time when column addresses are changed in the same row.

When changing row addresses, however, the fast access is difficult because the precharge must be made every time the row addresses are changed. As a result the following problem is caused especially in the dynamic RAM for storing video frame. In the dynamic RAM for storing video frame, as illustrated in FIG. 4, column addresses correspond addresses in the horizontal direction (direction of scanning lines) of a video frame and row addresses in the vertical direction in order to enable high-speed scanning by using the page mode during changing addresses in the direction of the scanning line and by executing precharge within the period of the horizontal retrace line. When drawing a horizontal line in a frame, signals are written in the RAM by changing only the column addresses by using the page mode and, therefore, high-speed operation can be executed. When drawing vertical or slant lines, however, the page mode cannot be used because the row addresses are changed and, therefore, high-speed operation is impossible. For this reason the display system adopting a conventional dynamic RAM for video frame recording has a considerable difference between operation speeds (generally about 4-5 times) when drawing vertical lines and when drawing horizontal lines. This difference is a demerit of the conventional system.

### SUMMARY OF THE INVENTION

An object of this invention is to provide a dynamic RAM for storing video frame whose operation speed in changing the row addresses is raised up to nearly the operation speed in changing the column addresses.

This invention provides a dynamic RAM for storing video frame which comprises a first memory cell array ($20_1$) for storing an odd field of the video frame, a second memory cell array ($20_2$) for storing an even field of the video frame, means for receiving address signals and accessing the memory cell specified by the address signals in one of the first and second memory cell arrays, and means for executing precharge of the other one of the first and second memory cell arrays which does not contain the memory cell specified by the address signals.

In the above-mentioned structure, when access is made in the first memory cell array, the precharge is made in the second memory cell array. Then, when the access is transferred to the second memory cell array, access can be immediately started because the second memory cell array has already precharged. At this time the first memory cell array is precharged to prepare for the next access. As the precharge in one memory cell array is executed in parallel with access of the other memory cell array, the access operation is, from the viewpoint limited to the access operation only, the same as the case where the precharge is not made, and therefore the fast access operation is possible.

## BRIEF DESCRIPTION OF THE DRAWINGS

FIG. 1 is a block diagram illustrating a general configuration of a dynamic semiconductor memory.

FIG. 2 is a circuit diagram illustrating access and precharge operations of the memory in FIG. 1.

FIG. 3 is a timing chart illustrating the timing of precharge signal generation in the memory in FIG. 1.

FIG. 4 illustrates the relationship between a video frame and column and row addresses of the dynamic RAM.

FIG. 5 is a block diagram illustrating configuration of an embodiment on a dynamic RAM of this invention.

FIG. 6 is a circuit diagram of a circuit for generating precharge signal in the embodiment of FIG. 5.

FIG. 7 is a timing chart illustrating the operation of the circuit in FIG. 6.

## DESCRIPTION OF THE PREFERRED EMBODIMENT

Referring to the drawings a preferred embodiment of this invention is described below.

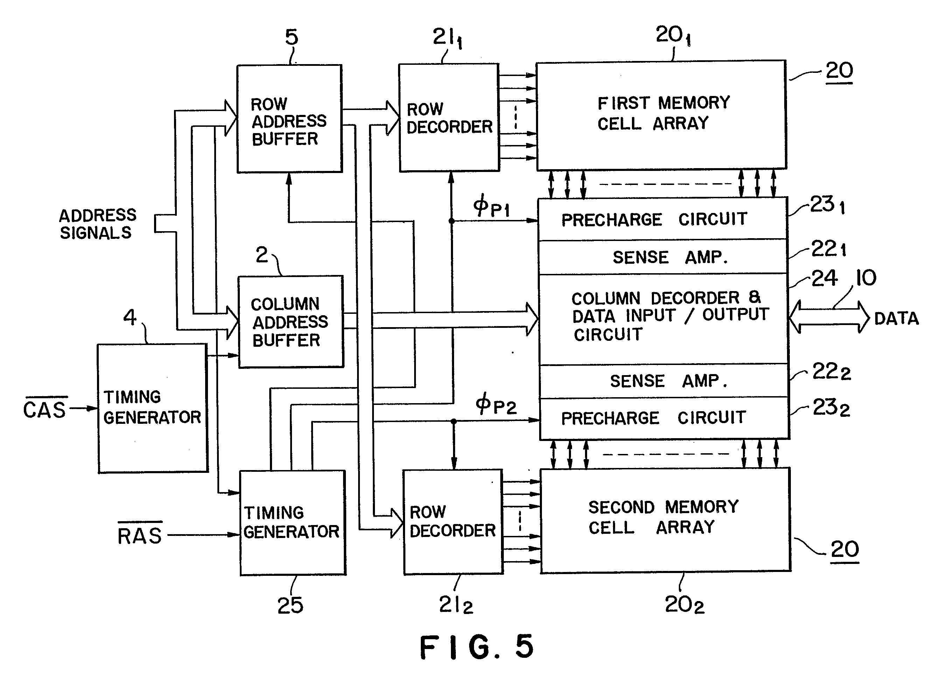

In FIG. 5, a block diagram illustrates the configuration of the embodiment of this invention, in which the same elements as those in FIG. 1 are assigned the same numbers.

The memory cell arrays 20 are separated into the first cell array $20_1$ and the second cell array $20_2$, each of which has rows of half number of scanning lines in a video frame and columns of the same number.

The first cell array $20_1$ stores signals in the odd field of the frame and the second cell array $20_2$ stores signals in the even field. Each scanning line in the odd field corresponds to each row of the first cell array $20_1$ and each scanning line in the even field corresponds to each row of the second cell array $20_2$. These two cell arrays $20_1$ and $20_2$ are respectively provided with row decoders $21_1$ and $21_2$, sense amplifiers $22_1$ and $22_2$, and precharge circuits $23_1$ and $23_2$. The connection of cell arrays $20_1$ and $20_2$ with the corresponding row decoders $21_1$ and $21_2$, sense amplifiers $22_1$ and $22_2$, and precharge Circuits $23_1$ and $23_2$ are the same as the circuits shown in FIG. 2. The first cell array $20_1$ and second cell array $20_2$ possess common columns, and use in common a column decoder and data input/output circuit 24. The relationship of the first cell array $20_1$ with the column decoder and data input/output circuit 24, and the relationship of the second cell array $20_2$ with the column decoder and data input/output circuit 24 are the same as shown in FIG. 2. The row address signals (bits), except the first bit $A_0$, are added to both the row decoders $21_1$ and $21_2$ through a row address buffer 5. This operation is synchronized with a down edge of $\overline{RAS}$ signal given to a timing generator 25. The column address signals are sent to the column decoder and the data input/output circuit 24 through the column address buffer 2. This operation is synchronized with a down edge of $\overline{CAS}$ signal given to the timing generator 4.

To specify the odd or even field, the first bit $A_0$ of the address signals takes "1" or "0" depending on the number of scanning line, that is, on whether the row address is of the odd or even number. Based on the first bit $A_0$ and the $\overline{RAS}$ signal, the timing generator 25 generates precharge signal $\Phi_{P1}$ and $\Phi_{P2}$ for the first and second memory cell arrays $20_1$ and $20_2$, and sends the signals to the precharge circuits $23_1$ and $23_2$, and row decoders $21_1$ and $21_2$.

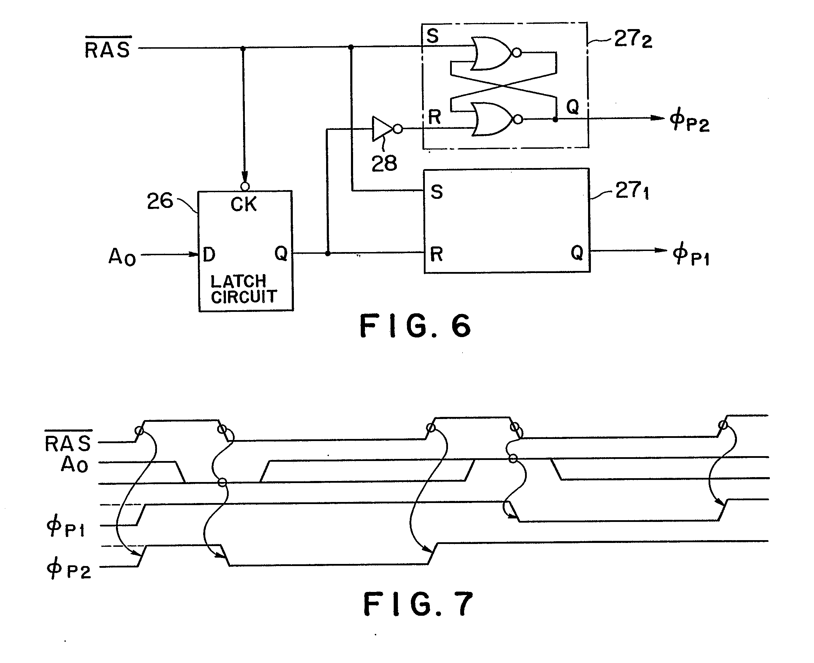

FIG. 6 shows a circuit in the timing generator 25 for generating precharge signals $\Phi_{P1}$ and $\Phi_{P2}$. This circuit has a latch circuit 26 which is a D-type flip-flop. The first bit $A_0$ is added to the D-input terminal of the flip-flop 26, and a reverse signal of $\overline{RAS}$ signal is added to the clock input terminal of the circuit 26. Therefore the value of the first bit $A_0$ at the down edge of $\overline{RAS}$ signal appears at the Q-output terminal of the latch circuit 26. This Q-output signal is added to the reset input terminal of the first RS-flip-flop circuit $27_2$ and simultaneously to the reset input terminal of the second flip-flop circuit 272 through the inverter 28. The $\overline{RAS}$ signal is added to each set-input terminal of the first and second RS flip-flop circuits $27_1$ and $27_2$. As shown

in FIG. 7, therefore, the precharge signal $\Phi_{P1}$ appearing at the Q output terminal of the first RS flip-flop circuit $27_1$ rises at the up edge of $\overline{RAS}$ signal and falls at the down edge of the $\overline{RAS}$ signal when the first bit $A_0$ has the value "1", and the precharge signal $\Phi_{P2}$ appearing at the Q-output terminal of the second RS flip-flop $27_2$ rises at the up edge of the $\overline{RAS}$ signal and falls at the down edge of $\overline{RAS}$ signal when the first bit $A_0$ has the value "0".

Referring to FIG. 5 again, the precharge circuit $23_1$ (or $23_2$) executes precharge of all columns of cell array $20_1$ (or $20_2$) when the precharge signals $\Phi_{P1}$ or ($\Phi_{P2}$) becomes at a high level. The row recorder $21_1$ (or $21_2$) receives and decodes the row address signals at the down edge of the precharge signal $\Phi_{P1}$ (or $\Phi_{P2}$), and selects an applicable row in the cell array $20_1$ (or $20_2$). As seen from FIG. 7, therefore, when the first bit $A_0$ is "1" (when the odd field is specified), the row decoder $21_1$ receives the row address signals at the down edge of $\overline{RAS}$ signal, and the access in the first cell array $20_1$ is executed. During this time precharge is executed in the second cell array $20_2$, because the precharge signal $\Phi_{P2}$ is at a high level. On the other hand, when the first bit $A_0$ is "0" (when the even field is specified), the precharge is, in contrast to the above-mentioned operation, made in the first cell array $20_1$ and the access is executed in the second cell array $20_2$. Thus the precharge is executed in one cell array when the access is executed in the other cell array.

In this embodiment the operation for drawing vertical or slant line is described below. When drawing a vertical or slant line, row address must be increased or decreased one by one, and therefore the first bit $A_0$ varies as "1, 0, 1, 0, ...", so that the odd and even fields are alternately specified. As a result, after the first cell array $20_1$ for storing the odd field is accessed, the second cell array $20_2$ for storing the even field is accessed; in short the access is alternately executed in the first and second cell arrays $20_1$ and $20_2$. On the contrary the precharge is in the reverse relationship to the access operation and alternately executed in the second cell array $20_2$ and the first cell array $20_1$. From the viewpoint of operation in one cell array, the access and precharge are alternately executed. From the viewpoint limited to access operation only, this operation is the same as successive access without the precharge. Although the lengths of the ordinary access time and precharge time are not precisely the same, the operation speed of this device approximately doubles that of conventional ones because the precharge time can be neglected as described above, thus approaching the operation speed of the page mode at a leap.

Reference signs in the claims are intended for better understanding and shall not limit the scope.

## Claims

1. A dynamic RAM for storing video frame characterized in comprising a first memory cell array ($20_1$) for storing an odd field of the video frame, a second memory cell array ($20_2$) for storing an even field of the video frame, means (2, 4, 5, 22, 24 and 25) for receiving address signals and accessing a memory cell specified by the adress signals in one of the first and second memory cell arrays, and means (25, $23_1$ and $23_2$) for executing precharge of the other one of the first and second memory cell arrays which does not contain the memory cell specified by the address signal.

2. The dynamic RAM as defined in claim 1, in which the precharge executing means comprises a first precharging means ($23_1$) for precharging the first memory cell array, a second precharging means ($23_2$) for precharging the second memory cell array, and a means (25) for receiving a predetermined part of the address signals which specifies selectively one of the odd and even fields and driving selectively one of the means for precharging the first and second memory cell arrays.

3. The dynamic RAM as defined in claim 2, in which the first memory cell array has multiple rows that respectively correspond to scanning lines in the odd field and multiple columns, the second memory cell array has multiple rows that respectively correspond to scanning lines in the even field and multiple columns in common use as the columns of the first memory cell array, and the means for accessing has a first row decoder ($21_1$) which selects from the first memory cell array a row specified by row address signals, a second row decoder ($21_2$) which selects from the second memory cell array a row specified by the row address signals, a means (25) for selectively driving one of the first and second row decoders which is specified the predetermined part of the address signals, and means (22 and 24) for selecting from the first and second memory cell arrays a column specified by column address signals and accessing a memory cell specified by the selected column and row.

FIG. I PRIOR ART

FIG. 2  PRIOR ART

EP 0 355 851 A2

$\overline{RAS}$

$\phi_P$

# FIG. 3 PRIOR ART

SCANNING LINES

COLUMN ADDRESS

ROW ADDRESS

VIDEO FRAME

RAM

# FIG. 4 PRIOR ART

F I G. 5

FIG. 6

FIG. 7